**Europäisches Patentamt**

**European Patent Office**

**Office européen des brevets**

(19)

(11) Veröffentlichungsnummer: **0 002 731**
**B1**

(12) **EUROPÄISCHE PATENTSCHRIFT**

(45) Veröffentlichungstag der Patentschrift: **22.09.82**

(21) Anmeldenummer: **78101669.6**

(22) Anmeldetag: **13.12.78**

(51) Int. Cl.³: **H 01 L 23/48,**
**H 01 L 21/28, H 01 L 21/60**

(54) **Dünnfilmstruktur für eine Kontaktanordnung und zugehöriges Herstellungsverfahren.**

(30) Priorität: **27.12.77 US 864182**

(43) Veröffentlichungstag der Anmeldung:
**11.07.79 Patentblatt 79/14**

(45) Bekanntmachung des Hinweises auf die Patenterteilung:
**22.09.82 Patentblatt 82/38**

(84) Benannte Vertragsstaaten:
**DE FR GB**

(56) Entgegenhaltungen:
**DE - A - 2 252 832**
**DE - A - 2 754 861**
**US - A - 4 012 767**

**JOURNAL OF APPLIED PHYSICS Vol. 46, No. 11, November 1975, New York**
**K. NAKAMURA et al "Interaction of Al layers with polycrystalline Si" Seiten 4678 bis 4684**

(73) Patentinhaber: **International Business Machines Corporation**
**Armonk, N.Y. 10504 (US)**

(72) Erfinder: **Chu, Wei-Kan**
**Square Woods Drive**
**LaGrangeville N.Y. 12540 (US)**
Erfinder: **Howard, James Kent**
**Cedar Hill Road**
**Fishkill N.Y. 12524 (US)**
Erfinder: **White, James Francis**
**17 Lake View Drive**
**Newburgh N.Y. 12550 (US)**

(74) Vertreter: **Gaugel, Heinz, Dipl.-Ing.**
**Schönaicher Strasse 220**
**D-7030 Böblingen (DE)**

## Dünnfilmstruktur für eine Kontaktanordnung und zugehöriges Herstellungsverfahren

Die Erfindung bezieht sich auf Dünnfilmstrukturen, wie sie für Kontaktanordnungen, vorzugsweise als Halbleiterkontakte, Anwendung finden können, und die eine Aluminiumschicht enthalten.

Die an ein Material bzw. eine Materialkombination zum Aufbau . eines ohmschen oder eine Schottky-Sperrschicht aufweisenden Kontaktes mit einem Silicium-Halbleitersubstrat zu stellenden Forderungen sind gleichermaßen vom elektrischen wie auch vom chemischen Standpunkt aus relativ streng. Aus der großen Anzahl dem mit der Auslegung von Halbleiterschaltungen befaßten Fachmann bekannten sog. metallurgischen Systeme für Kontaktanordnungen stellt Aluminium bzw. ein mit geringen Anteilen Kupfer versehenes Aluminium nahezu alleinstehend das erfolgreichste Metall für Verbindungsmetallisierungen von Silicium-Planartransistoren und integrierten Schaltkreisen dar. Es ist jedoch ebenfalls allgemein bekannt, daß Aluminium eine besondere Tendenz zu schädlichen Wechselwirkungen mit Silicium aufweist, insbesondere in Verbindung mit bei hohen Temperaturen vorzunehmenden Verfahrensschritten. Darüber hinaus gilt für Aluminium, daß es als Kontaktmaterial zu Silicium weder eine besonders hohe noch eine besonders niedrige Schottky-Barriere bildet. Mit einem üblichen Aluminium-Siliciumkontakt läßt sich eine Schottky-Barriere in der Größenordnung von 0,68 bis etwa 0,72 eV erreichen.

Aus den genannten Grünten kann dieses System in solcher Form nicht zur Bildung von Schottky-Dioden mit einer relativ geringen Schottky-Barriere, z. B. von etwa 0,5 eV, eingesetzt werden. Auf der anderen Seite wurden jedoch erst unlängst Schaltkreisfamilien entwickelt, z. B. DTL, I²L und Schottky-Transistor-Logik, bei denen Schottky-Dioden mit einer solchen ausgesprochen niedrigen Schottky-Barriere erforderlich sind, vgl. z. B. A. W. Peltier "Advances in Solid-State Logic- A New Approach to Bipolar LSI: C³L", 1975 IEEE International Solid-State Circuits Conference, Digest of Technical Papers, Seiten 168/169.

Komplexer aufgebaute Halbleiterschaltungen erfordern darüber hinaus auf demselben Halbleitersubstrat Schottky-Diodenstrukturen mit hohen als auch mit niedrigen Schottky-Barrieren. Außerordentlich nützlich wäre überdies ein metallurgisches System, mit dem nicht nur diese verschiedenen Schottky-Kontakte, sondern zusätzlich auch ohmsche Kontakte herstellbar wären, so daß jeder dieser Kontakttypen in einem überwiegend einheitlich ausgestalteten Verfahren prozessierbar wäre. Gemäß einem älteren Vorschlag (Aktenzeichen 78 10 0525.1) ist zu Lösung dieser Problematik eine Struktur angegeben, die eine in Kontakt mit dem Silicumsubstrat stehende untere Tantalschicht, eine Zwischenschicht aus Chrom und eine Deckschicht aus Aluminium vorsieht, wobei die Chromschicht zur Verhinderung von durch das Aluminium veranlaßten Beeinflussungen der Tantalschicht oder des Siliciumsubstrats dient. Ohne die diffusionshindernde Chromschicht würde die dann zustandekommende Wechselwirkung die Schottky-Barriere des Tantal-Siliciumkontaktes so weit erhöhen, daß damit praktisch die bei einem Aluminium-Siliciumkontakt vorliegenden Verhältnisse einträten.

Bei der Vorgehensweise nach dem genannten älteren Vorschlag ist jedoch eine sorgfältige Prozeßkontrolle zur Verhinderung einer unerwünschten Oxidation unerläßlich. Darüber hinaus ist es in jedem Fall wünschenswert, die Anzahl der zum Einsatz kommenden verschiedenen Metalle zu verringern.

Weiterhin ist es aus einer Patentanmeldung der Anmelderin (DE—OS 27 54 861) bekannt, zur Bildung sehr zuverlässiger Schottky-Dioden eine aus Aluminium und einem Übergangsmetall aufgebaute Kontaktstruktur vorzusehen. Damit ist jedoch statt der angestrebten 0,5 eV lediglich ein thermisch stabiler unterer Wert der Schottky-Barriere von etwa 0,62 eV erreichbar.

Breite Anwendung hat darüber hinaus ein metallurgischer Kontaktaufbau für eine Schottky-Diode mit einer Schottky-Barriere von 0,5 eV gefunden, der eine Titan-Wolfram-Legierung verwendet. Es bestehen jedoch erhebliche Schwierigkeiten, Titan-Wolfram zu verdampfen, wodurch für die Herstellung lediglich Kathodenzerstäubungsverfahren zur Verfügung stehen. Darüber hinaus ist bei solchen Schottky-Kontakten eine mit zunehmender Temperatur zu beobachtende Drift der Schottky-Barrierenspannung zu beobachten.

Die im Zusammenhang mit Aluminium festgestellten Reaktionen mit anderen Metallen und Metallsiliciden wirken sich manchmal nützlich und manchmal schädlich aus. Soweit in dem oben erwähnten Fall eine aus Aluminium und einem Übergangsmetall aufgebauten Anordnung nützlich für die Erzielung einer Schottky-Kontaktstruktur ist, besteht auf der anderen Seite jedoch die Gefahr, daß Aluminium in und durch andere Metalle, wie Tantal oder Platinsilicide, zu einer darunterliegenden Schicht, z. B. aus einkristallinem oder polykristallinem Silicium durchdringt und an der Siliciumoberfläche Erosionsschäden verursacht. Schließlich kann davon ausgegangen werden, daß Aluminium auch mit Gold und Silber, Metallen aus der Gruppe der seltenen Erden, z. B. Gd, Ln, Y, Yb, Pr usw., Blei und Zinloten und amorphem Silicium Reaktionen in Form meist schädlicher Wechselwirkungen eingeht.

Die Erfindung, wie sie in den Patentansprüchen gekennzeichnet ist, löst die Aufgabe, in einer derartigen Aluminium enthaltenden Kontaktanordnung, die vorzugsweise als Halbleiterkontakt ausgeführt ist, derartige Beeinträchtigungen zu beseitigen, die der Erzielung von Schottky-Dioden mit niedriger Schottky-Barriere entgegenstehen. Dabei sollen sich Möglichst Schottky- und ohmsche Kontakte in einer möglichst gleich ausgestalteten Verfahrensabfolge herstellen lassen.

Die durch die Erfindung erreichten Vorteile sind im wesentlichen darin zu sehen, daß infolge der als Zwischenschicht vorgesehenen Aluminiumschicht mit einem hohen Anteil Aluminiumoxid temperaturstabile Schottky-Dioden mit geringen Werten für die Spannung der Schottky-Barriere erreichbar sind. Die Kontaktanordnungen sind je nach der Vorbehandlung des Substrats mit verschiedenen Eigenschaften auszulegen, so daß für die eigentliche Ausbildung der Kontaktanordnung ein einheitlicher und hinsichtlich der Anzahl der zum Einsatz kommenden Metalle vereinfachter Prozeß anwendbar ist. Im übrigen können die jeweiligen Substrate bei der Prozeßdurchführung durchgängig in der Vakuumeinrichtung belassen werden, d.h. sie müssen nicht für die verschiedenen Schichtauftragungen aus dem Vakuumsystem entnommen werden.

Die Erfindung wird im folgenden anhand von Ausführungsbeispielen unter Zuhilfenahme der Zeichnungen näher erläutert.

Es zeigt:

Fig. 1 eine ausschnittsweise Querschnittsdarstellung einer Halbleiteranordnung mit einer ersten Ausführung der erfindungsgemäßen Metallurgie;

Fig. 2 eine zweite Ausführungsform der Erfindung und

Fig. 3 ein Ablaufdiagramm, mit dessen Hilfe bevorzugte Herstellungswege für die Bildung der Metallurgie entsprechend den Figuren 1 und 2 veranschaulicht werden sollen.

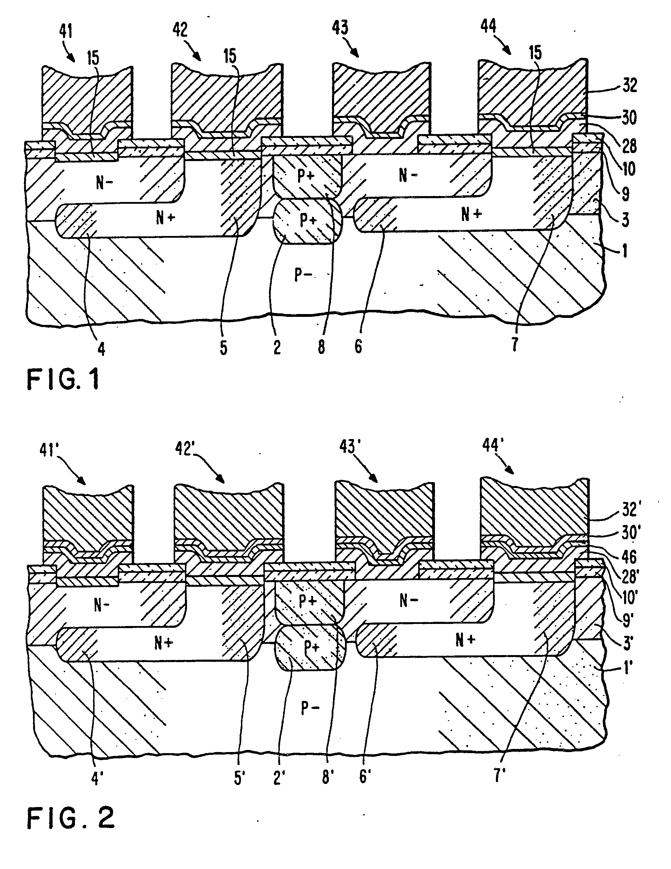

Fig. 1 stellt einen Bereich aus einer Halbleiteranordnung dar, in dem die neue Ausführung der Metallurgie über Dotierungsgebieten in einem Halbleiterkörper enthalten ist. Dabei ist natürlich davon auszugehen, daß normalerweise viele Tausende von Bauelementen, wie Dioden, Transistoren, Widerstände etc. auf demselben Halbleiterplättchen vorgesehen sein können.

Das mit 1 bezeichnete Halbleitersubstrat besteht aus P-leitendem Silicium mit einem typischen spezifischen Widerstandswert von etwa 10Ω·cm. Auf dem Halbleitersubstrat 1 erstreckt sich eine N- Schicht 3 mit einer bevorzugten Dotierungskonzentration von $1·10^{16}$ bis $8·10^{16}$ Atomen/cm$^3$. Ferner sind die vergrabenen Gebiete 4 und 6 mit ihren jeweiligen (zur Oberfläche hin reichenden) Anschlußgebieten 5 und 7 dargestellt. Zur Trennung der N-leitenden Gebiete sind im Substrat ferner P+ Isolationsgebiete 2 und 8 in der gezeigten Weise angeordnet.

Die mit 2, 4 und 6 bezeichneten Gebiete werden vorteilhaft durch konventionelle Diffusionsverfahren unter Vorsehung von entsprechend ausgebildeten Maskenfenstern, in denen das Substrat 1 freiliegt, hergestellt. Typische N+ Dotierungsstoffe sind Arsen oder Phosphor, ein typischer P+ Dotierungsstoff ist Bor. Die Maskierungsschicht wird mittels konventioneller Ätzverfahren anschließend vom Substrat entfernt, worauf man eine Epitaxieschicht 3 aufwachsen läßt. Dabei können die mit 2, 4 und 6 bezeichneten Gebiete in die Epitaxieschicht 3 ausdiffindieren. Auf die Oberfläche der Epitaxieschicht 3 wird dann erneut eine Maskierungsschicht aufgebracht, die in typischen Fällen aus einer Zusammensetzung einer Siliciumoxidschicht 9 und einer Siliciumnitridschicht 10 besteht. In dieser Doppelschicht werden dann erneut Maskenfenster geöffnet, durch die die Metallurgie zur Bildung von Kontakten mit verschiedenen Dotierungsgebieten innerhalb der Epitaxieschicht 3 aufgebracht wird.

An den Kontaktstellen 41, 42 und 44 wird jeweils eine Schicht 15 aus Platinsilicid oder aus einem anderen geeigneten Metallsilicid gebildet. Derartige Verfahren zur Bildung von Platinsilicidschichten bei Halbleitern sind an sich bekannt. Ein bevorzugtes Herstellungsverfahren ist ferner Gegenstand des eingangs erwähnten älteren Vorschlags der Anmelderin (Aktenzeichen 78 10 0525.1). Im Rahmen der Vorliegenden Anmeldung kann daher auf Einzelheiten der Herstellung dieser Schichten 15 verzichtet werden. Es soll lediglich festgehalten werden, daß das Platin mittels und in derselben Reaktionskammer aufgedampft werden kann, die auch für die weiteren Verfahrensschritte der noch näher zu beschreibenden Metallurgie verwendet wird.

Bei der Ausbildung der Metallurgie kann ferner bevorzugt von der sog. Lift-Off-Technik Gebrauch gemacht werden, vgl. z. B. die US-Patentschrift 4 004 044 bzw. den genannten älteren Vorschlag. Weitere Verfahrensschritte zur Ausbildung der metallurgischen Schichtmuster sind die an sich gut bekannten Naß- oder Trockenätztechniken. Die genannte Lift-Off-Technik liefert jedoch demgegenüber überlegenere Ergebnisse, wobei insbesondere ein geringerer Flächenbedarf für die Verbindungen sowie geringere Verunreinigungsprobleme hervorzuheben sind.

Die bis hierher behandelten Maßnahmen werden im Rahmen der vorliegenden Erfindung daher vorausgesetzt und bilden nicht für sich deren Gegenstand.

An den Kontaktstellen 41, 42 und 44 erstreckt sich jeweils auf der Platinsilicidschicht 15 eine Schicht 28 aus Tantal. Diese Schicht 28 kann alternativ auch aus Zirkon, Nickel, Hafnium, Titan oder anderen Übergangsmetallen bestehen, die eine geringe Schottky-Barriere aufweisen. Legierungen von Übergangsmetallen, z. B. 90% Ta/10% W oder 80% Ta/20% Zr, erweisen sich ebenfalls als nützlich. Die Schicht 28 erstreckt sich im Kontaktbereich 43 direkt auf der N- Schicht 3, um eine Schottky-Diode mit geringer Schottky-Barriere zu bilden. Über der Schicht 28 liegt eine dünne Schicht 30 aus reichlich Aluminiumoxid enthaltendem Aluminium. Fertiggestellt wird dieses Kontaktsystem durch eine direkt auf der Schicht 30 aufliegende Aluminiumschicht 32. Die mit 41, 42, 43 und 44 bezeichneten Kontaktstellen bilden somit eine Schottky-Diode mit hoher Barriere, einen ohmschen Kontakt, eine Schottky-Diode mit niedriger Barriere sowie einen weiteren ohmschen Kontakt. Die mit 42 und 44 bezeichneten ohmschen Kontakte wirken dabei als Kathoden für die jeweils zugehörigen und mit 41 und 43 bezeichneten Anoden.

Es wurde gefunden, daß die reichlich Aluminiumoxid enthaltende Aluminiumschicht 30 als wirksame Barriere gegen das Durchdringen der Tantalschicht 28 von Seiten der Aluminiumschicht 32 wirkt. Es ist anzunehmen, daß die Sauerstoffanteile in der Schicht 30 vorzugsweise in die Aluminium-Korngrenzen dieser Schicht eingelagert sind, wodurch die Diffusion von der Aluminiumschicht 32 durch die Schicht 30 in die Schicht 28 auf ein Minimum reduziert wird. Gleichwohl reicht das übrige Aluminium in der Schicht 30 für eine ausreichende elektrische Leitfähigkeit zwischen der Schicht 32 und dem restlichen Kontaktaufbau aus, ohne daß ein untragbar hoher Serienwiderstand in Kauf zu nehmen wäre.

Fig. 2 zeigt eine weitere Ausführungsform der Erfindung, bei der zusätzlich noch die Bildung eines Oxids eines Übergangsmetalls, z. B. einer Tantaloxidschicht 46, vorgesehen ist. Die übrigen Gebiete und Schichten entsprechen der in Fig. 1 gezeigten Struktur und sind demnach entsprechend bezeichnet.

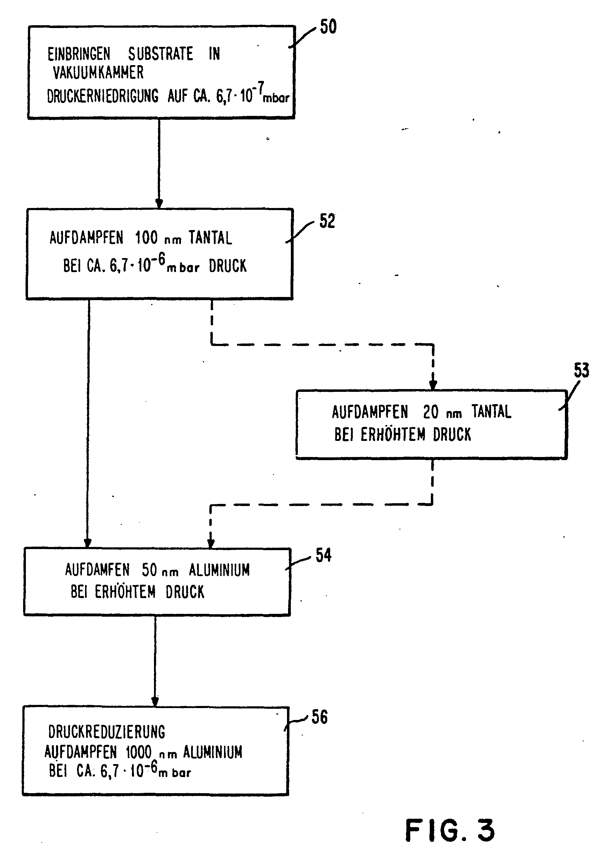

Ein bevorzugtes Herstellungsverfahren für ein solches Metallurgiesystem für derartige Kontaktstrukturen ist in Fig. 3 illustriert. Der dort mit 53 bezeichnete Verfahrensschritt entspricht dabei dem zusätzlichen Schritt zur Bildung der in Fig. 2 gezeigten Schichtstruktur.

Im ersten in Fig. 3 mit 50 bezeichneten Verfahrensschritt werden die Halbleitersubstrate in eine standardmäßige Aufdampfeinrichtung eingebracht. Der Niederschlag der jeweiligen Metallisierung erfolgt am besten mit einer Elektronenstrahl-Verdampfungsquelle, wie sie beispielsweise von der Firma Airco-Temescal Corp. als Modell FC1800 lieferbar ist. Ähnliche Ausführungsformen von Verdampfungsapparaturen werden von anderen Herstellern angeboten. Die Reaktionskammer wird zunächst über einen längeren Zeitraum evakuiert, wobei besondere Bedeutung dem Entgasen der Wände der Aufdampfeinrichtung zukommt, um möglichst weitgehend jegliche Sauerstoff-Kontamination während des Aufdampfvorganges auszuschalten. Bei einem anfänglichen Druck in der Vakuumkammer von weniger als $5,3 \cdot 10^{-7}$ mbar beträgt der maximale Druck nach Beginn des Aufdampfvorganges etwa $3,3 \cdot 10^{-6}$ mbar.

Nach dem konventionellen und deshalb in Fig. 3 nicht dargestellten Aufdampfen und Sintern des Platins wird die Übergangsmetallschicht aus Tantal mit einer Schichtdicke von etwa 100 nm auf das Substrat aufgedampft, wobei ein Druck von etwa $6,7 \cdot 10^{-6}$ mbar aufrecht erhalten wird, vgl. den Verfahrensschritt 52. Die Tantalschicht wird sehr langsam, vorzugsweise mit einer Aufdampfrate von etwa 2 nm/sec aufgedampft, um eine sehr feinkörnige Struktur zu erzielen.

Anschließend wird bei erhöhtem Druck, d.h. bei einem reduzierten Vakuum der Aufdampfvorgang für Aluminium begonnen, vgl. den Verfahrensschritt 54 in Fig. 3. Darunter ist zu verstehen, daß durch eine leichte Luft-, Sauerstoff- oder Wassereinströmung etwas Sauerstoff in die Aufdampfkammer gelangen können soll. Das erhöht den Druck auf Werte von vorzugsweise etwa $2,67 \cdot 10^{-5}$ mbar, obwohl auch ein noch höherer Druck angewendet werden kann, wenn in der Schicht 30 ein größerer $Al_2O_3$-Anteil erwünscht ist. Durch den derartig ausgestalteten Verfahrensschritt besteht schließlich die auf der Tanalschicht 28 (in Fig. 1) gebildete Schicht 30 aus Aluminiumoxid $Al_2O_3$ und daneben aus reinem Aluminium. Die bevorzugte Aufdampfrate für das Aluminium liegt dabei bei etwa 100 nm/min, bis eine Schichtdicke im Bereich von etwa 10 bis 100 nm an reichlich Aluminiumoxid enthaltendem Aluminium gebildet ist. Eine Schichtdicke von etwa 50 nm für die Schicht 30 wurde im Hinblick auf einen geringen Serienwiderstand als vorteilhaft festgestellt. Bei einer demgegenüber geringeren Aufdampfrate nimmt der $Al_2O_3$-Anteil zu.

Die Reaktionskammer wird dann erneut evakuiert und es erfolgt der Aufdampfvorgang für eine etwa 1000 nm dicke Aluminiumschicht als Verbindungsmetallisierung, vgl. 32 in Fig. 1 sowie den Verfahrensschritt 56 in Fig. 3. Die bevorzugte Dicke der zu erstellenden Aluminiumschicht 32 liegt zwischen etwa 850 und 1000 nm. Dem reinen Aluminium wird dabei ein mit geringen Kupferanteilen versehenes Aluminium vorgezogen. Soweit im Rahmen dieser Beschreibung demnach von "Aluminium" oder "reinem Aluminium" gesprochen wird, soll dadurch folglich nickt eine Kupfer- bzw. Kupfer-Silicium-Beimengung zum Aluminium ausgeschlossen sein. Auch weitere Aluminium-Legierungen oder Aluminium-Übergangsmetall-Verbindungen sind anwendbar.

Es schließt sich daran ein Temper- bzw. Wärmebehandlungsschritt bei 400°C über etwa eine Stunde an, um die statistische Verteilung der Schottky-Barrierenwerte der Schottky-Dioden aneinander anzugleichen bzw. einzuengen. Damit ist der grundsätzliche Verfahrensgang abgeschlossen, so daß Schottky-Kontakte mit großen und kleinen Schottky-Barrieren vorliegen. Wie bereits im Zusammenhang mit der Beschreibung von Fig. 1 erwähnt wurde, sind mit 41 und 42 Anode und Kathode der Schottky-Diode mit hoher Schottky-Barriere bzw. mit 43 und 44 Anode und Kathode der Schottky-Diode mit demgegenüber niedrigerer Schottky-Barriere bezeichnet.

Insgesamt liegen damit unter Benutzung derselben Metallurgie insgesamt drei unterschiedliche Kontakttypen vor. Die Kathoden beider Schottky-Dioden stellen ohmsche Kontakte zu den N+ Gebieten 5 und 7 in der Schicht 3 dar. Natürlich kann dieselbe Vorgehensweise Anwendung finden, um derartige ohmsche Kontakte auch zu anderen aktiven Gebieten in der Halbleiteranordnung herzustellen, beispielsweise zu Emitter- und Basisgebieten von Transistoren. Die Anode 41 der Schottky-Diode mit hoher Schottky-Barriere verwendet das reichlich Aluminiumoxid enthaltende Aluminium zwischen der Platinsilicidschicht 15 und der Aluminiumschicht 32 als diffusionsverhindernde Zwischenschicht, wobei die Platinsilicidschicht eine gegenüber der Anode 43 der Schottky-Diode ohne Platinsilicidschicht erhöhte Schottky-Barriere ergibt. Bei der in Fig. 1 mit 43 bezeichneten Kontaktstruktur steht die Schicht 28 aus dem Übergangsmetall direkt in Verbindung mit dem N- Silicium der Schicht 3.

Um Schottky-Diodenstrukturen mit hoher Schottky-Barriere zu bilden, ist eigentlich die Schicht 30 aus einem Übergangsmetall nicht erforderlich. Unter fertigungstechnischen Gesichtspunkten ist es jedoch praktischer, das Übergangsmetall als durchgehende Schicht aufzubringen und mit allen Kontaktöffnungen auszustatten.

In dem Verfahrensablaufdiagramm nach Fig. 3 ist eine weitere Ausbildung des bisher beschriebenen Verfahrens dargestellt, wonach eine einen hohen Anteil Tantaloxid enthaltende Tantalschicht zwischen der Tantalschicht 28 und der mit 30 bezeichneten Zwischenschicht vorgesehen wird. Dieser Schritt ist dort mit 53 bezeichnet und in unterbrochenen Linien zwischen den mit 52 und 54 bezeichneten Verfahrensschritten dargestellt. Der einzige Unterschied zwischen dieser Verfahrensweiterbildung und dem vorher beschriebenen Verfahren besteht darin, daß das Einströmenlassen von etwas Wasser, Luft oder Sauerstoff in die Aufdampfapparatur vorgenommen wird, nachdem reines Tantal oder ein anderes Übergangsmetall aufgebracht wurde und bevor das Tantal in der Reaktionskammer durch Aluminium ersetzt wird. Vorzuziehen ist eine etwa 20 nm oder weniger dicke Schicht aus reichlich Tantaloxid enthaltendem Tantal und etwa 50 nm dicke Schicht aus reichlich Aluminiumoxid enthaltendem Aluminium für diese doppelten Zwischenschichten zwischen dem reinen Tantal einerseits und dem reinen Aluminium andererseits.

Der mit der Vorsehung dieser zweiten Zwischenschicht aus reichlich Tantaloxid enthaltendem Tantal erzielte Vorteil besteht darin, daß nunmehr eine doppelte Sicherheit dagegen besteht, daß freies Aluminium in Kontakt mit dem reinen Tantal kommen kann. Der dabei zugrunde liegende Gesichtspunkt ist, wie bereits erwähnt wurde, der, daß Aluminium zur Reaktion mit Tantal und Silicium neigt, wodurch die Schottky-Barriere der zugehörigen Schottky-Diodenstruktur angehoben würde. Bisher war die Bildung von Tantaloxid allgemein meist unerwünscht. Es wurde gefunden, daß der Sauerstoff im Tantaloxid bei erhöhten Temperaturen, d.h. bei etwa 400°C und darüber, beweglich ist, woraus eine Veränderung der Schottky-Barriere bzw. des sog. Idealitätsfaktors der Schottky-Diode resultiere.

Die reichlich Aluminiumoxid enthaltende Aluminiumschicht 30 muß nicht notwendigerweise in direktem Kontakt mit der Aluminiumschicht 32 stehen, um die genannten vorteilhaften Eigenschaften zu erreichen. Beispielsweise könnte die z. B. in Fig. 1 mit 30 bezeichnete Schicht in einer Sandwich-Anordnung zwischen zwei Schichten aus einem Übergangsmetall vorgesehen sein, indem eine zweite Schicht eines Übergangsmetalls vor dem Aufdampfen der Aluminiumschicht 32 auf die Schicht 30 aufgedampft wird. Dieser aufwendiger ausgestaltete Prozeß würde ebenfalls noch eine Reaktion des Aluminiums in der Schicht 32 mit der Tantalschicht 30 oder dem Silicium in der Schicht 3 wirksam verhindern, wie das bei dem oben beschriebenen Verfahren der Fall ist; zusätzlich würde die zweite Tantalschicht mit einem Teil der Aluminiumschicht 32 während des erwähnten Wärmebehandlungsschrittes reagieren, wodurch die Eigenschaften bezüglich des Elektromigrationsphänomens verbessert würden.

Mit einer Auger-Spektroskopanalyse wurde ein Anteil von kleiner 10% Aluminiumoxid in dem Aluminiumoxid enthaltenden Aluminium festgestellt. Der Anteil von Tantaloxid in der zugehörigen Tantalschicht beträgt weniger als 40%. Weitere Einzelheiten von Analysen an derartigen Schichten finden sich in einem Aufsatz im Journal of Applied Physics, Band 45, No. 7, Juli 1974, auf den Seiten 2858 bis 2866.

Als ein Beispiel für das mit dem neuen Verfahren und der neuen Struktur erreichbare Ergebnis wurde eine Schottky-Diode mit einer Schottky-Barriere von 0,47 eV erhalten. Der Wert der Schottky-Barriere bleibt dabei stabil, selbst wenn die Diodenstruktur eine Stunde bis zu Temperaturen von 500°C einer Wärmebehandlung unterworfen wird. Dieser Temperatur-Zeit-Faktor geht weit über die unter Betriebsbedingungen zu erwartenden Verhältnisse hinaus und hat sich als zuverlässige Testangabe für die Langzeitstabilität von Halbleitern erwiesen. Der Idealitätsfaktor $\eta$ beträgt anfänglich nach dem Niederschlag 1,0 und steigt nach der Wärmebehandlung auf 1,1 an; darin ist ein für Schottky-Dioden vollauf akzeptabler Wert zu sehen. Als Alternative zu der bevorzugten Aufbringung der metallurgischen Schichten mittels Aufdampfen kann gleichermaßen auch ein HF-Kathodenzerstäubungsverfahren (Sputtern) eingesetzt werden. Eine typische Apparatur dafür ist die von der Firma Materials Research Corporation angebotene Mehrfach-Target-Sputtereinrichtung Modell 822. Un in die Sputtereinrichtung etwas Wasser, Luft oder Sauerstoff einströmen lassen zu können, sollte ein entsprechendes Leckventil vorgesehen sein. Das Aufsputtern des Übergangsmetalls kann in situ, d.h. ohne Unterbrechung der Vakuumverhältnisse in der Reaktionskammer erfolgen. Der Luft-, Sauerstoff- oder Wassereinlaß wird während der Ausbildung der reichlich Aluminiumoxid enthaltenden Aluminiumschicht vorgenommen.

Daneben bestehen weitere Verfahrensausgestaltungen für die Bildung der metallurgischen Schichten, wenn man eine Sputtereinrichtung einsetzt. Beispielsweise kann die reichlich Aluminiumoxid enthaltende Aluminiumschicht durch einen reaktiven Sputtervorgang von Aluminium in einer Argon-Sauerstoff-Gasmischung innerhalb der Reaktionskammer vorgenommen werden, um den Anteil von Aluminium und Aluminiumoxid in der diffusionsverhindernden Zwischenschicht zu steuern. Eine ähnliche Verfahrensausgestaltung kann für die Bildung der weiteren Zwischenschicht mit einem reichlich Oxid enthaltenden Übergangsmetall angewendet werden.

Wie bereits eingangs angegeben wurde, ist die vorliegende Erfindung überall dort mit Nutzen einsetzbar wo eine Aluminium-Wechselwirkung bzw. -diffusion mit einem anderen Material auftreten kann. Durch Vorsehung einer reichlich Aluminiumoxid enthaltenden Aluminiumschicht läßt sich eine solche Diffusion verhindern. Beispielsweise wird in Feldeffekttransistorstrukturen oder ladungsgekoppelten Halbleiteranordnungen weithin polykristallines Silicium als Gate-Elektrode mit einer darüber sich erstreckenden Aluminiumschicht für die Verbindungsmetallisierung verwendet. Während des Niederschlags von Aluminium tendiert dieses dazu, durch das aus Silicium bestehende Gateelektrodenmaterial zu diffundieren, vgl. z. B. den Aufsatz von K. Nakamura mit dem Titel "Interaction of Al Layers with Polycristalline Si" im Journal of Applied Physics, Band 46, No. 11, November 1975.

Die reichlich Aluminiumoxid enthaltende Aluminiumschicht verhindert darüber hinaus die Diffusion von Aluminiumatomen in einkristallines und amorphes Silicium. Gleichermaßen unterbindet eine solche zwischenschicht eine Wechselwirkung von anderen Metallen anstelle von aluminium, wie z. B. Gold und Silber, mit hinsichtlich diesen reaktiven Metallen aus der Gruppe der Seltenen Erden, z. B. Gd, Lu, Y, Yb, Pr etc. Wie ebenfalls bereits oben erwähnt wurde, tritt die Wechselwirkung von Aluminium gegenüber anderen Metallen insbesondere als ein Problem bei Temperaturen im 350°C und höher in Erscheinung, da Aluminium bei diesen Temperaturen sehr hohe Diffusionsgeschwindigkeiten aufweist.

Ein weiteres Anwendungsgebiet dieser Erfindung liegt ferner in der Reduzierung oder Verhinderung eines Aluminium-Bleioder Aluminium-Zinn-Eutektikums, das sich vorzugsweise an den Aluminiumkorngrenzen, bei Temperaturen zwischen etwa 200 und 300°C bildet.

**Patentansprüche**

1. Dunnfilmstruktur für eine Kontaktanordnung, vorzugsweise einen Halbleiterkontakt, mit einer Aluminiumschicht (32) und einer Schicht (3, 15, 28) aus einem hinsichtlich Aluminium reaktiven Metall, Metallsilicid oder Silicium, gekennzeichnet durch eine Zwischenschicht (30) aus Aluminium mit einem hohen Anteil Aluminiumoxid.

2. Dünnfilmstruktur nach Anspruch 1, dadurch gekennzeichnet, daß sie den folgenden Schichtaufbau enthält:

— ein Silicium-Halbleitersubstrat (3);
— eine darüberliegende Schicht (28) aus einem Übergangsmetall wie Tantal, Zirkon, Hafnium, Titan oder Nickel;
— eine Zwischenschicht (30) aus Aluminium mit einem hohen Anteil Aluminiumoxid;
— eine obere Aluminiumschicht (32).

3. Dünnfilmstruktur nach Anspruch 1 oder 2, gekennzeichnet durch ein Halbleitersubstrat vom N-Leitungstyp und eine so gebildete Schottky-Diodenstruktur (41, 43).

4. Dünnfilmstruktur nach Anspruch 3 für einen Schottky-Kontakt mit einer Schottky-Barriere von etwa 0,5 eV, dadurch gekennzeichnet, daß das Halbleitersubstrat eine N-leitende Dotierungskonzentration von etwa $1 \cdot 10^{16}$ bis $8 \cdot 10^{16}$ Atomen/cm$^3$ aufweist und die Übergangsmetallschicht (28) aus Tantal besteht.

5. Dünnfilmstruktur nach Anspruch 1 oder 2, gekennzeichnet durch ein Halbleitersubstrat vom N+ Leitungstyp mit einer darauf im Kontaktbereich zusätzlich vorgesehenen Metallsilicidschicht (15) und eine so gebildete ohmsche Kontaktstruktur (42, 44).

6. Dünnfilmstruktur nach mindestens einem der vorhergehenden Ansprüche 2 bis 5, dadurch gekennzeichnet, daß die Dicke der Übergangsmetallschicht (28) etwa 100 nm und der Zwischenschicht (30) weniger als etwa 100 nm beträgt.

7. Dünnfilmstruktur nach mindestens einem der Ansprüche 2 bis 6, gekennzeichnet durch eine zwischen der Übergangsmetallschicht (28') und der aus Aluminium mit einem hohen Anteil Aluminiumoxid bestehenden ersten Zwischenschicht (30') vorgesehene zweite Zwischenschicht (46) aus neben dem Übergangsmetall einen hohen Anteil des zugehörigen Oxids enthaltenden Material (Fig. 2).

8. Dünnfilmstruktur nach mindestens einem der vorhergehenden Ansprüche, gekennzeichnet durch im Rahmen einer integrierten Halbleiterschaltung nebeneinander vorhandene Metall-Halbleiterkontakte (41—44; 41'—44') in Form ohmscher (42, 44; 42', 44') bzw. Schottky-Kontakte (41, 41') hoher Schottky-Barriere einerseits, die auf N- bzw. N+ dotierten Siliciumgebieten mit jeweils einem darüber vorgesehenen Metallsilicidschichtbereich angeordnet sind, sowie in Form von Schottky-Kontakten (43, 43') mit niedriger Schottky-Barriere direkt über N— dotierten Siliciumgebieten andererseits, wobei alle Kontaktanordnungen bezüglich der übrigen daraufliegenden Schichten (28, 30, 32 bzw. 28', 46, 30', 32') gleichermaßen ausgebildet sind und insbesondere unter der aus Aluminium bestehenden Deckschicht (32, 32') eine Schicht (30, 30') aus Aluminium mit einem hohen Anteil Aluminiumoxid enthalten.

9. Verfahren zur Herstellung einer Dünnfilmstruktur nach mindestens einem der vorhergehenden Ansprüche, dadurch gekennzeichnet, daß in einer Vakuumeinrichtung auf mindestens einen Bereich eines Silicium-Halbleitersubstrats eine Schicht (28) aus einem Übergangsmetall wie Tantal, Zirkon, Hafnium, Titan oder Nickel bei so niedrigem Druck in der Vakuumeinrichtung aufgebracht wird, daß es zu keiner Oxidationsbildung dieser Schicht kommt, daß darauf bei demgegenüber erhontem Druck in einer Sauerstoff enthaltenden Atmosphäre in der Vakuumeinrichtung eine Zwischenschicht (30) aus Aluminium mit einem hohen Anteil Aluminiumoxid und schließlich bei demgegenüber erneut reduziertem Druck auf diese Zwischenschicht (30) eine obere Aluminiumschicht (32) aufgebracht wird.

10. Verfahren nach Anspruch 9, dadurch gekennzeichnet, daß zwischen dem Aufbringen der Übergangsmetallschicht (28') und der aus Aluminium mit einem hohen Anteil Aluminiumoxid bestehenden ersten Zwischenschicht (30') bei gegenüber dem vorhergehenden Verfahrensschritt (52 in Fig. 3) erhöhtem Druck in der Vakuumeinrichtung noch eine zweite Zwischenschicht (46) aus neben dem Übergangsmetall einen hohen Anteil des zugehörigen Oxids enthaltendem Material augebracht wind.

11. Verfahren nach Anspruch 9 oder 10, dadurch gekennzeichnet, daß die Schichten mittels Aufdampf oder Kathodenzerstäubungsverfahren aufgebracht werden.

12. Verfahren nach den Ansprüchen 9 bis 11, dadurch gekennzeichnet, daß die Übergangsmetallschicht aus Tantal und mit einer Schichtdicke von etwa 100 nm gebildet wird, daß die erste Zwischenschicht aus Aluminium mit einem hohen Anteil Aluminiumoxid mit einer Schichtdicke kleiner als etwa 100 nm und die ggf. vorgesehene zweite Zwischenschicht aus Tantal mit einem hohen Anteil Tantaloxid in einer Schichtdicke von etwa 20 nm aufgebracht wird.

## Claims

1. Thin film structure for a contact arrangement, preferably a semiconductor contact, comprising an aluminium layer (32) and a further layer (3, 15, 28) of a metal, metal silicide or silicon reactive with regard to aluminium, characterized by an intermediate layer (30) of aluminium with a high aluminium oxide content between the aluminium layer and the further layer.

2. Thin film structure as claimed in claim 1, characterized by the following layer structure:

a silicon semiconductor substrate (3);

a superimposed layer (28) consisting of a transition metal as tantalum, zirconium, hafnium, titanium, or nickel;

an intermediate layer (30) of aluminium with a high aluminium oxide content; and

an upper aluminium layer (32).

3. Thin film structure as claimed in claim 1 or 2, characterized by a semiconductor substrate of N-conductivity type, and by a Schottky diode structure (41, 43) so formed.

4. Thin film structure as claimed in claim 3 for a Schottky contact with a Schottky barrier of approximately 0.5 eV, characterized in that the semiconductor substrate has an N-conductive doping concentration of approximately $1.10^{16}$ to $8.10^{16}$ atoms/cm$^3$, and in that the transition metal layer (28) consists of tantalum.

5. Thin film structure as claimed in claim 1, or 2, characterized by a semiconductor substrate of N+ conductivity type, with a metal silicide layer (15) additionally provided thereon in the contact zone, and an ohmic contact structure so formed (42, 44).

6. Thin film structure as claimed in at least one of the preceding claims 2 to 5, characterized in that the thickness of the transition metal layer (28) is approximately 100 nm, and that of the intermediate layer (30) less than approximately 100 nm.

7. Thin film structure as claimed in at least one of claims 2 to 6, characterized by a second intermediate layer (46, Fig. 2) which is provided between the transition metal layer (28') and the first intermediate layer (30') consisting of aluminium with a high aluminium oxide content, and which consists of a transition metal which has a high content of the associated oxide.

8. Thin film structure as claimed in at least one of the preceding claims, characterized by metal semiconductor contacts (41—44) 41'—44') provided side by side in an integrated semiconductor circuit, said contacts comprising ohmic (42, 44; 42', 44') and Schottky contacts (41, 41') of a high Schottky barrier which are arranged on N— or N+-doped silicon areas with an intermediate metal silicide layer, and Schottky contacts (43, 43') of a low Schottky barrier arranged directly on N-doped silicon areas on the other, all contact arrangements being of the same design with regard to the remaining superimposed layers (28, 30, 32 and 38', 46, 30', 32'), and comprising, particularly beneath the covering layer (32, 32') of aluminium, an aluminium layer (30, 30') with a high aluminium oxide content.

9. A method of making a thin film structure as claimed in at least one of the preceding claims, characterized in that in a vacuum device, on at least one zone of a silicon semiconductor substrate a layer (28) of a transition metal as tantalum, zirconium, hafnium, titanium, or nickel is applied at such a lower pressure in the vacuum device that there is no oxidation of this layer, that subsequently, with a relatively increased pressure in an oxygen-containing atmosphere in the vacuum device an intermediate layer (30) of aluminium with a high aluminium oxide content is applied, and in that finally with the pressure once again reduced an upper aluminium layer (32) is applied on this intermediate layer (28).

10. Method as claimed in claim 9, characterized in that between the application of the transition metal layer (28'), and the first intermediate layer (30') consisting of aluminium with a high aluminium oxide content, with the pressure increased relative to the preceding process step (52 in Figure 3) in the vacuum device, a second intermediate layer (46) is applied of a material comprising a transition metal with a high content of the associated oxide.

11. Method as claimed in claim 9 or 10, characterized in that the layers are deposited by means of evaporation or cathode sputtering processes.

12. Method as claimed in any one of claims 9 to 11, characterized in that the transition metal layer is formed of tantalum, and with a layer thickness of approximately 100 nm, in that the first intermediate layer of aluminium with a high aluminium oxide content is applied with a layer thickness smaller than approximately 100 nm, and in that the second intermediate layer of tantalum with a high tantalum oxide content provided, if necessary is applied with a layer thickness of approximately 20 nm.

### Revendications

1. Structure à films minces pour un contact, de préférence avec un semi-conducteur, comportant une couche d'aluminium (32) et une couche (3, 15, 28) respectivement de silicium, ou de siliciure de métal, ou de métal chacun réagissant avec l'aluminium, caractérisée en ce qu'elle comporte une couche intermédiaire (30) d'aluminium ayant un contenu élevé d'oxyde d'aluminium.

2. Structure à films minces selon la revendication 1 caractérisée en ce qu'elle comporte successivement les couches suivantes:
   un substrat semi-conducteur de silicium (3);
   une couche de recouvrement (28) d'un métal de transition tel que le tantale, le zirconium, le hafnium, le titane ou le nickel;
   une couche intermédiaire (30) d'aluminium ayant un contenu élevé d'oxyde d'aluminium; et
   une couche supérieure d'aluminium (32).

3. Structure à films minces selon la revendication 1 ou 2, caractérisée en ce qu'elle comporte un substrat semi-conducteur du type de conductivité N et une structure de diode de Schottky (41, 43) ainsi formée.

4. Structure à films minces selon la revendication 3 pour un contact de Schottky ayant une hauteur de barrière d'environ 0,5 eV, caractérisée en ce que le substrat semi-conducteur a une concentration de dopage de conductivité N comprise entre environ $1.10^{16}$ et $8.10^{16}$ atomes/cm$^3$, et en ce que la couche de métal de transition (28) est composée de tantale.

5. Structure à films minces selon la revendication 1 ou 2, caractérisée en ce qu'elle comporte un substrat semi-conducteur du type de conductivité N$^+$ avec une couche de siliciure de métal (15) prévue en plus sur celui-ci dans la région de contact, et une structure de contact ohmique (42, 44) ainsi formée.

6. Structure à films minces selon au moins l'une des revendications 2 à 5 précédentes, caractérisée en ce que l'épaisseur de la couche de métal de transition (28) est d'environ 100 nm, et celle de la couche intermédiaire (30) inférieure à environ 100 nm.

7. Structure à films minces selon au moins l'une des revendications 2 à 6, caractérisée en ce qu'une seconde couche intermédiaire (46) est disposée entre la couche de métal de transition (28') et la première couche intermédiaire (30') ayant un contenu élevé d'oxyde d'aluminium, ladite seconde couche intermédiaire étant composée d'un matériau (figure 2) ayant, en plus du métal de transition, un contenu élevé de son oxyde associé.

8. Structure à films minces selon au moins l'une des revendications précédentes, caractérisée par des contacts semi-conducteurs de métal (41—44; 41'—44') placés côte-à-côte dans un circuit semi-conducteur intégré sous la forme de contacts ohmiques (42, 44; 42', 44'), de contacts de Schottky (41, 41') à barrière élevée, qui sont disposés sur des régions de silicium dopées N ou N$^+$, chacune étant recouverte d'une région de couches de siliciure de métal, et sous la forme de contacts de Schottky (43, 43') à barrière faible, disposés directement sur les régions de silicium du type N; tous les dispositifs de contact étant formés par rapport aux couches restantes superposées (28, 30, 32 et 28', 46, 30', 32' respectivement) de façon uniforme et ayant en particulier en dessous de la couche de recouvrement (32, 32') en aluminium, une couche (30, 30') d'aluminium avec un contenu élevé d'oxyde d'aluminium.

9. Procédé pour fabriquer une structure à films minces selon au moins l'une des revendications précédentes, caractérisé en ce que l'on dépose dans un appareil à vide sur au moins une région d'un substrat semi-conducteur de silicium, une couche (28) d'un métal de transition comme le tantale, le zirconium, le hafnium, le titane ou le nickel à une pression tellement faible dans l'appareil à vide que cette couche ne peut s'oxyder, en ce que l'on dépose sur cette couche à une pression plus élevée en atmosphère d'oxygène dans l'appareil à vide une couche intermédiaire (30) d'aluminium ayant un contenu élevé d'oxyde d'aluminium, et en ce que l'on dépose enfin à une pression de nouveau réduite une couche d'aluminium supérieure (32) sur cette couche intermédiaire (30).

10. Procédé selon la revendication 9, caractérisé en ce que l'on dépose une seconde couche intermédiaire (46) d'un matériau qui, outre ce métal de transition, a un contenu élevé de son oxyde associé entre la couche de métal de transition (28') et la première couche intermédiaire (30') d'aluminium ayant un contenu élevé d'oxyde d'aluminium, avec une pression plus élevée dans l'appareil à vide en comparaison de celle de l'étape de procédé précédente (52 de la figure 3).

11. Procédé selon la revendication 9 ou 10, caractérisé en ce que les couches sont déposées à l'aide des procédés d'évaporation ou de pulvérisation cathodique.

12. Procédé selon l'une quelconque des revendications 9 à 11, caractérisé en ce que la couche de métal de transition est formée de tantale avec une épaisseur de couche d'environ 100 nm, en ce que l'on dépose la première couche intermédiaire d'aluminium ayant un contenu élevé d'oxyde d'aluminium et une épaisseur de couche inférieure d'environ 100 nm et éventuellement la seconde couche intermédiaire de tantale ayant un contenu élevé d'oxyde de tantale et une épaisseur de couche d'environ 20 nm.

FIG. 1

FIG. 2

FIG. 3